(19) Europäisches Patentamt
European Patent Office
Office européen des brevets

(11) Publication number: **0 398 577 A1**

(12) # EUROPEAN PATENT APPLICATION

(21) Application number: **90304970.8**

(22) Date of filing: **09.05.90**

(51) Int. Cl.[5]: **C08L 33/00, C08F 120/02, C09J 133/00, C09J 11/00, B32B 7/12, C08L 95/00, C09J 7/00**

(30) Priority: **16.05.89 US 352424**

(43) Date of publication of application: **22.11.90 Bulletin 90/47**

(84) Designated Contracting States: **AT BE CH DE DK ES FR GB GR IT LI LU NL SE**

(71) Applicant: **ROHM AND HAAS COMPANY**
**Independence Mall West**
**Philadelphia Pennsylvania 19105(US)**

(72) Inventor: **Graziano, Louis Christopher**
**162 Willow Lane**
**Warrington, PA 18976(US)**
Inventor: **Will, Albert Steven**
**180 Eaton Court**
**Langhorne, PA 19047(US)**
Inventor: **Kaplan, Fred Allen**
**835 Cathcart Road**
**Blue Bell, PA 19422(US)**

(74) Representative: **Buckley, Guy Julian et al**
**ROHM AND HAAS (UK) LTD. European Operations Patent Department Lennig House**
**2 Mason's Avenue**
**Croydon CR9 3NB(GB)**

(54) **Acrylic compositions containing crosslinking agents and impact modifiers.**

(57) A composition comprises by weight a) 1-30% crosslinking agent(s); b) 0.1%-25% impact modifier(s), and c) 45-98.9% functional acrylic polymer comprising about 0.1-20% by weight of monomer units containing one or more functional groups which are reactive with said crosslinking agent(s). The composition may be used in or as a contact or laminating adhesive, an architectural coating, a caulk, a mastic, a cement binder or a paper coating.

EP 0 398 577 A1

# ACRYLIC COMPOSITIONS CONTAINING CROSSLINKING AGENTS AND IMPACT MODIFIERS

This invention is concerned with acrylic compositions comprising crosslinking agents and impact modifiers, uses of such compositions, a process of laminating at least two substrates together with such compositions, and a solid adhesive film comprising such compositions.

Acrylic adhesive and coating compositions have been known in the art for several decades and have found utility in a variety of applications. Ways have been developed to improve the properties of these compositions and to use these compositions to improve the properties of other materials.

R.J. Moulds and T.R. Baldwin describe toughened adhesives in their article, "Toughened Adhesives for Structural Applications", Applications Report, Butterworth & Co. (1983). These toughened adhesives were based on modification of either acrylics with rubbers or epoxy with rubbers.

M.Ochi and J.P. Bell described modification of epoxy resins with a carboxyl-terminated copolymer of n-butyl acrylate and acrylic acid in "Rubber-Modified Epoxy Resins Containing High Functionality Acrylic Elastomers", Journal of Applied Polymer Science, Volume 29, pages 1381-1391(1984). K. W. Harrison describes modification of epoxies or acrylics with a low molecular weight rubber in his article "Applications of Toughened Epoxy and Acrylic Adhesives", Adhesives, volume 12, pages 121-140(1988).

The preparation and use of acrylic impact modifiers in rigid thermoplastics (such as acrylic polymers and vinyl halide polymers) are described in US-A-3,808,180. US-A-4,482,659 describes compositions comprising epoxy and high molecular weight elastomers of butadiene-containing copolymers.

None of the above references teach or describe novel compositions of the present invention comprising crosslinking agent, a functional acrylic polymer and an impact modifier.

Polymers which have glass transition temperatures at or near their use temperature make poor dry laminating adhesives for flexible applications due to their glassy behavior during delamination. The polymers' limited ability to absorb stresses and direct these away from the adhesive/substrate interface results in low bond strength and slip- stick peel failure. Attempts to overcome these limitations by using lower Tg adhesive polymers results in adhesives which have a low modulus and which are difficult to handle as thin, unsupported adhesive films. An object of the present invention to provide a composition which may be flexible and may have improved peel adhesion without loss of mechanical properties. A further object of this invention to provide compositions which may be useful as a laminating adhesive in, for example, the fabrication of flexible electronic circuitry. Another object of this invention to provide compositions which may be useful as an unsupported, dry film adhesive.

The compositions of this invention comprise:

a) 1% to 30% by weight of crosslinking agent(s)

b) 0.1% to 25% by weight of impact modifier(s) and

c) 45% to 98.9% by weight of a functional acrylic polymer, wherein said acrylic polymer comprises from 0.1% to 20% by weight of monomer units containing one or more functional groups which are reactive with said crosslinking agent(s). These compositions combine the high glass transition temperature(Tg) and thermosetting characteristics of an acrylic/crosslinker system with the stress absorbing characteristics of an impact modifier to achieve both high modulus and high bond strength.

A wide variety of crosslinking agents are useful in this invention at a level of about 1% to about 30% by weight of the composition; preferably about 2% to about 20%; more preferably about 3% to about 10%. Crosslinking agents are any multifunctional compounds which are capable of reacting with the functional groups of said functional acrylic polymer. Preferred crosslinking agents include, but are not limited to, epoxy resins, melamine/formaldehyde-type resins, $\beta$-hydroxyalkylamides, aziridines, (amino)amides, multifunctional amines and metal ion crosslinkers. The preferred crosslinking agents are the epoxy resins.

A wide variety of epoxy resins are useful in this invention as crosslinking agents, such as, for example, those described in "Epoxy Resins" by S. Sherman, J. Gannon, G. Buchi and W.R. Howell in the Kirk-Othmer-Othmer Encyclopedia of Chemical Technology, 3rd Edition, Vol. 9, pp 267-290, John Wiley and Sons, New York, NY (1980). The preferred epoxy resins which are useful in this invention include diglycidyl ether derivatives of bisphenol A or bisphenol F; diglycidyl ether derivatives of $C_1$-$C_{30}$ aliphatic diols or polyols; diglycidyl ether derivatives of polyglycols, such as diethylene glycol, triethylene glycol, poly-(ethylene glycol), poly(propylene glycol), poly(ethylene glycol-co-polypropylene glycol), or poly(butylene glycol); diglycidyl ether derivatives of cycloaliphatic dicarboxylic acids; diglycidyl ether derivatives of aromatic materials, such as diglycidyl ether derivatives of novolak resins (e.g. epoxy phenol novolak resins or epoxy cresol novolak resins), polynuclear phenols, p-aminophenol-based resins, triazine-based resins, methylenedianiline-based resins, or hydantoins; epoxidized cycloolefins, epoxidized drying oils, and epoxidation products derived from other unsaturated resins.

The epoxy resins can be used as is, dissolved in solvent, or, preferably, dispersed in water. Dispersions of the epoxy resin in water can be prepared either with conventional surfactants or reactive surfactants containing epoxide functionality. Any solvent which does not react with the epoxy functionality or other functionality of said functional acrylic polymer under the conditions of use can be utilized in the compositions of this invention.

The impact modifiers are useful in the compositions of the present invention at a level of about 0.1% to about 25% by weight of the composition; preferably about 0.5% to about 20%; more preferably about 1.0% to about 10%. Impact modifiers as used herein are known in the art and generally mean low Tg (i.e.<25 °C, preferably <10 °C, more preferably <-25 °C, wherein the Tg refers to the elastomeric portion of the impact modifier), low modulus, rubbery, elastomeric materials which form a discrete, dispersed phase in rigid thermoplastics and thereby increase the toughness of the composition. Preferred impact modifiers for use in this invention include the following generic classes: polyolefins including EPDM polymers [poly(ethylene-co-propylene-co-butadiene)] and chlorinated polyethylenes (CPE), ABS polymers [poly(acrylonitrile-co-butadiene-co-styrene)], MABS polymers [poly(methacrylate-co-acrylonitrile-co-butadiene-co-styrene)], MBS polymers [poly(methacrylate-co-butadiene-co-styrene)], acrylate polymers, EVA polymers [poly(ethylene-co-vinyl acetate)], acrylic polymers (such as described in US-A-3,808,180, and silicone rubber polymers. Preferred impact modifiers include MBS polymers, acrylic polymers and crosslinked silicone rubber polymers. The most preferred impact modifiers are the acrylic polymers impact modifiers such as described and claimed in US-A- 3,808,180.

Functional acrylic polymers are used in the compositions of this invention at a level of about 45% to about 98.9% by weight. The functional acrylic polymer can be prepared by any polymerization process known in the art, such as emulsion, suspension, dispersion or solution polymerization. Preferably the functional acrylic polymer is prepared by emulsion polymerization. The functional acrylic polymer is prepared from acrylic monomers such as acrylic acid, methacrylic acid and the $C_1$-$C_{24}$ alkyl esters of acrylic and methacrylic acids. Examples of ($C_1$-$C_{24}$) alkyl groups of esters of acrylic and methacrylic acids which may be used in the invention include: methyl, propyl, isopropyl, butyl, isobutyl, sec-butyl, t-butyl, amyl, isoamyl, t-amyl,hexyl, cyclohexyl, 2-ethylhexyl, octyl, decyl, lauryl, myristyl, cetyl and stearyl groups. Specific examples include: methyl methacrylate, ethyl acrylate, or n-butyl acrylate, 2-ethylhexyl acrylate, lauryl methacrylate, isodecyl methacrylate, methyl acrylate, ethyl methacrylate, sec-butyl acrylate and tbutyl methacrylate.

Other comonomers may be used along with the acrylic monomers to prepare the functional acrylic polymers useful in the present invention. These comonomers include other ethylenically-unsaturated, polymerizable monomers such as, for example, vinylidiene halides, vinyl halides, acrylonitrile, methacrylonitrile, vinyl esters such as vinyl formate, vinyl acetate and vinyl propionate, and mixtures of ethylene and such vinyl esters, acrylic and methacrylic acid esters of ether alcohols such as diethylene glycol monoethyl or monobutyl ether methacrylate, ($C_1$-$C_{10}$) alkyl esters of beta-acryloxypropionic acid and higher oligomers of acrylic acid, styrene and alkyl substituted styrenes and vinyl aromatics including alpha-methylstyrene, mixtures of ethylene and other alkylolefins such as propylene, butylene, pentene and the like, vinyl esters such as methyl vinyl ether, ethyl vinyl ether, vinyl 2-methoxyethyl ether and vinyl 2-chloroethyl ether.

Additional comonomers include hydroxy functional vinyl monomers such as 2-hydroxyethyl methacrylate, 2-hydroxyethyl acrylate, 3-hydoxypropyl methacrylate, butanediol acrylate, 3-chloro-2-hydroxypropyl acrylate, 2-hydroxypropyl acrylate, and 2-hydroxypropyl methacrylate. Further examples of useful monomers include the partial esters of unsaturated aliphatic dicarboxylic acids and particularly the alkyl half esters of such acids. Examples of such partial esters are the alkyl half esters of itaconic acid, fumaric acid and maleic acid wherein the alkyl group contains 1 to 6 carbon atoms.

Other monomers useful in preparing the functional acrylic polymers of this invention are the carboxylic acids such as acrylic acid, methacrylic acid, acryloxycarboxylic acid and higher oligomers of acrylic acid and mixtures thereof, ethacrylic acid, itaconic acid, aconitic acid, crotonic acid, citraconic acid, maleic acid, fumaric acid, alpha-chloracrylic acid, cinnamic acid, mesaconic acid and mixtures thereof.

Additional comonomers also include ethylenically-unsaturated monomers containing amine, amide, anhydride and thiol functionality.

The functional acrylic polymer must comprise by weight from about 0.1% to about 20% (preferably about 0.5% to about 5.0%, more preferably about 1% to about 3% and most preferably about 1% to about 2%) of monomers containing one or more functional groups which are reactive with said crosslinking agent(s). Some examples of functional groups which may be suitable for this invention include carboxylic acids, aliphatic amines, aromatic amines, hydroxyls, amides, thiols, anhydrides, epoxides, and phosphorus groups of the formula:

$$\begin{array}{c} O \\ || \\ -Z-P-OR_1 \\ | \\ OR_2 \end{array}$$

where $R_1$ and $R_2$ independently are H or $C_1$-$C_{12}$ alkyl or aryl and Z is -O- or -C-.

Preferably the functional groups are carboxylic acids.

The functional acrylic polymer useful in this invention can have any glass transition temperature (Tg) and any molecular weight. Preferably, the acrylic polymer has a Tg from about -20°C to about 100°C; more preferably from about 10°C to about 50°C. Preferably, the functional acrylic polymer has a weight average molecular weight of about 50,000 or greater.

The most preferred monomers used to polymerize said functional acrylic polymer are one or more of butyl acrylate, ethyl acrylate, acrylic acid, isobutyl methacrylate, methyl methacrylate, acrylonitrile, methacrylic acid, acryloxypropionic acid and 1, 3-butylene glycol dimethacrylate.

The functional acrylic polymer can be prepared by a single stage polymerization process or it can be prepared by sequential polymerization to yield multi-stage polymer particles. Preferably the functional acrylic polymer is prepared by emulsion polymerization.

The composition of this invention can be prepared by mixing or blending the functional acrylic polymer, crosslinking agent and impact modifier in any sequence. The compositions of the invention may include other optional ingredients in an amount up to about 50% by weight of total composition. The optional ingredients include catalyst, dispersants, thickeners, coalescents, filler, pigments, stabilizers, plasticizers, preservatives and other conventional additives used in formulating adhesives and coatings. The compositions of this invention have a variety of use applications, but they are especially useful as a dry, solid film laminating adhesive for fabricating flexible electronic circuitry. For electronic laminating applications, an adhesive generally must have a peel strength of about 8 lbs. per linear inch (143 kg/m) or greater. The adhesive compositions of the present invention give dramatic improvements in peel strength (i.e. about 12-15 lbs./linear inch (214-268 kg/m)) when used as an electronic laminating adhesive.

The laminating adhesive of this invention is particularly useful in many flexible electronic circuitry applications, such as fabrication of circuit boards, switches, structural members, and electrical tape (and the like).

In another aspect, the present invention is concerned with a process for laminating two or more substrates together comprising the use as a laminating adhesive of a composition comprising:

a) about 1% to about 30% by weight of crosslinking agent(s)

b) about 0.1% to about 25% by weight of impact modifier(s), and

c) about 45% to about 98.9% by weight functional acrylic polymer(s) wherein said acrylic polymer(s) comprises from about 0.1% to about 20% by weight of monomer units containing one or more functional groups which are reactive with said crosslinking agent(s). Preferably the substrates are flexible substrates, such as copper foil, iron foil, nickel foil, aluminum foil, silver foil, gold foil, polyimide film, polyester film, polyester fibre, glass fibers,polyvinyl flouride film, polyethylene film, polypropylene film and aramid paper, which may be used in the fabrication of flexible electronic circuitry.

The adhesive is preferably used to attach a metallic foil such as copper, iron, nickel, aluminum, silver and gold to a variety of substrates, such as, for example, films of polyimide, polyester, epoxy-reinforced polyester fibers, epoxy-modified glass fibers, polyvinyl flouride, polyethylene, polypropylene and aramid paper. The adhesive may also useful in bonding the polymeric films together.

The adhesive composition of this invention can be applied to the substrate by conventional application procedures such as spraying, dipping, brushing, roll coating or as a dry solid by either a batch lamination or a continuous lamination process using heat and pressure. The adhesive can be applied in varying thickness, preferably at a thickness of about 0.1 to about 2 mils.

The following examples are presented to demonstrate this invention. All parts and percentages used in the examples are on a weight basis unless otherwise indicated.

## EXAMPLE I

Using conventional emulsion polymerization techniques, a functional acrylic polymer within the scope of

this invention having the composition 58% butyl acrylate/40% acrylonitrile/2% acrylic acid was prepared as follows: A 5-liter stirred flask, equipped for charging reactants and for temperature regulation, was swept with nitrogen and charged with 630 grams deionized water. After the flask contents were heated to 85° C, the following were charged: 1.2 grams ammonium persulfate dissolved in 45 grams deionized water, 111 grams 45% solids emulsion preform, 22.4 grams deionized water rinse. Over the next three hours a monomer emulsion consisting of 948 grams deionized water, 32.4 grams 23% sodium dodecylbenzene sulfonate, 966 grams butyl acrylate, 666.2 grams acrylonitrile, and 33.3 grams acrylic acid; and an initiator solution consisting of 2 grams ammonium persulfate dissolved in 135 grams deionized water, were fed at a constant rate while maintaining a reaction temperature of 83-84° C. At the end of the polymerization a free radical chaser was employed to decrease the level of unreacted monomers and the flask contents were cooled. The final emulsion polymer had 46.7% solids.

EXAMPLE II

An impact modifier within the scope of this invention was prepared as follows:

A mixture of methacrylate-functional siloxane (prepared by platinum catalyst addition of allyl methacrylate to a methyl hydrodimethylsiloxane copolymer, MW = 13300) (95 g.), allyl methacrylate (5.g.), ethyl acetate (233 g.), initiator (Vazo 52 available from DuPont Company) (0.5 g.), surfactant (DS-4 available from Alcolac, Inc.) (2.1 g.), and water (100 g.) was homogenized using a Ross Micro-Mixer Emulsifier at about 9,000 rpm for 3 minutes. The resulting emulsion, having a particle size in the 0.1 to 1 micron range, was poured into a 1-liter kettle containing hot water (70 g., 65° C) to effect a suspension polymerization. After the mixture was held for 2 hours at 65° C, ethyl acetate was removed by stripping and residual monomer was destroyed with additional initiator. The final product had a total solids of 31.6% and an average particle size less than 1 micron.

EXAMPLE III

Various adhesive compositions within the scope of this invention were prepared by blending functional acrylic polymer from Ex. I with crosslinking agent and impact modifier. The peel strength of the various adhesive compositions were measured and compared to comparative adhesive compositions.

To measure peel strength, adhesive films were prepared by coating approximately 2 dry mils of adhesive composition onto a siliconized paper release liner (Polyslick available from H.P. Smith Co.). The adhesive composition was dried for 4-5 minutes at 180° F. Laminates were prepared by placing the adhesive film between the treated side of copper foil (treated, rolled, annealed copper from Norplex Oak Co.) and polyimide film (Kapton available from DuPont Co.). The laminate was cured using an hydraulic press at 350° F and 250-400 pounds per square inch for 30-45 minutes. Peel strength was measured following the standard test method of the Institute of Interconnecting and Packaging of Electronic Circuitry Test Methods Manual (IPC-TM-650), method 2.4.9.B. The results are presented in Table I below.

TABLE I

| (parts by weight) | | | | | | | | | |
|---|---|---|---|---|---|---|---|---|---|
| Sample | Acrylic Functional Polymer | Crosslinking Agent | | | | Impact Modifier | | | Peel Strength |
| | (Ex. 1) | Genepoxy 370H55 | CMD W55-5003 | V | W | X | Y | Z | (pounds/inch) |
| A(comparative) | 100 | -- | -- | -- | -- | 5 | -- | -- | 5.6 |
| B(comparative | 100 | 6 | -- | -- | -- | -- | -- | -- | 10.1 |
| C | 100 | 6 | -- | -- | -- | 5 | -- | -- | 13.5 |
| D | 100 | 6 | -- | -- | -- | -- | 5 | -- | 13.6 |
| E | 100 | -- | 6 | -- | -- | 5 | -- | -- | 12.2 |
| F | 100 | 6 | -- | -- | -- | -- | -- | 1 | 11.4 |
| G | 100 | 6 | -- | -- | -- | -- | -- | 7 | 13.0 |
| H(comparative) | 100 | -- | -- | 4.2 | -- | -- | -- | -- | 4.9 |
| I | 100 | -- | -- | 4.2 | -- | 10 | -- | -- | 6.0 |
| J(comparative) | 100 | -- | -- | -- | 3 | -- | -- | -- | 7.8 |
| K | 100 | -- | -- | -- | 3 | 10 | -- | -- | 13.0 |

Genepoxy 370H55 = aqueous emulsion of diglycidyl ether of Bisphenol A resin available Daubert Chemical Co.

CMD W55-5003 = nonionic dispersion of novolak epoxy resin available from Hitek Co.

V = melamine formaldehyde crosslinking agent(Cymel 303, 50% solution, available from American Cyanamid Co.)

W = beta-hydroxyalkylamide crosslinking agent (50% solution, commercially available from Rohm and Haas Co.)

X = acrylic impact modifier comprising 80% butyl acrylate/20% methyl methacrylate (commercially available from Rohm and Haas Co.)

Y = silicone rubber impact modifier from Ex. II

Z = MBS impact modifier comprising 10.8% methyl methacrylate/75% butadiene/14.2% styrene (commercially available from Rohm and Haas Co.)

## EXAMPLE IV

Electrical properties, such as volume resistivity, surface resistance, dielectric constant and dissipation factor, were evaluated for several representative compositions within the scope of this invention prepared in Ex. III. Electrical properties were measured following the standard test methods of the Institute of Interconnecting and Packaging of Electronic Circuitry Test Methods Manual (IPC-TM-650). The results are presented in Table II below and demonstrate that the compositions of this invention have satisfactory electrical properties.

Table II

| Sample | Volume Resistivity (megohm-cm) | Surface Resistance (megohm) | Dielectric Constant | Dissipation Factor |
|---|---|---|---|---|
| C | $2X10^6$ | $1X10^5$ | 3.5 | 0.01 |
| D | $2x10^8$ | $2x10^5$ | 3.5 | 0.01 |
| E | $3x10^8$ | $5x10^5$ | 3.5 | 0.01 |

EXAMPLE V

Following the procedures of Ex. III, various adhesive composition within the scope of this invention were prepared and evaluated for peel strength. Comparative compositions falling outside this invention were also evaluated. The results are presented in Table III.

Table III

| (parts by weight) | | | | |
|---|---|---|---|---|
| Sample | Functional Acrylic Polymer* | Epoxy Resin (Genepoxy 370H55) | Impact Modifier** | Peel Strength (lbs./inch) |
| L(comparative) | 100 | -- | -- | 4.5 |
| M(comparative) | 100 | 6 | -- | 5.3 |
| N | 100 | 6 | 0.2 | 6.7 |
| O | 100 | 6 | 7.3 | 8.5 |
| P | 100 | 6 | 18.0 | 8.5 |

*Functional acrylic polymer is a commercial emulsion polymer having a composition of 51% methyl methacrylate, 47.3% butyl acrylate and 1.7% acrylic acid available from Rohm and Haas Company.
**Impact Modifier is a commercial acrylic impact modifier comprising 80% butyl acrylate and 20% methyl methacrylate (available from Rohm and Haas Co.)

EXAMPLE VI

Using a conventional sequential emulsion polymerization process below, a multi-stage functional acrylic polymer within the scope of this invention was prepared having the following composition:
85% 1st stage: 65% butyl acrylate 11% methyl methacrylate/22% acrylonitrile/2% acrylic acid
15% 2nd stage: 72% methyl methacrylate/25% 1,3-butyleneglycol dimethacrylate/3% acrylic acid

A 5-liter stirred flask, equipped for charging reactants and for temperature regulation, was swept with nitrogen and charged with 630 grams deionized water. After the flask contents were heated to 85°C, the following were charged: 4.8 grams ammonium persulfate dissolved in 45 grams deionized water, 11 grams 45% solids emulsion preform, 22.4 grams deionized water rinse, 2 grams 0.5N sulfuric acid and 13.5 grams 0.1% ferrous sulfate heptahydrate. Over the next three hours a monomer emulsion consisting of 948 grams deionized water, 32.4 grams 23% sodium dodecylbenzene sulfonate, 1082 grams butyl acrylate, 183.2 grams methyl methacrylate, 366.4 grams acrylonitrile, and 33.3 grams acrylic acid; and an initiator solution consisting of 2 grams ammonium persulfate dissolved in 135 grams deionized water, were fed at a constant rate while maintaining a reaction temperature of 83-84°C. At the end of the polymerization a free radical chaser was employed to decrease the level of unreacted monomers and the flask contents were cooled. To 1000 grams of this initial polymer composition were added 80.3 grams of a blend of 72 parts methyl methacrylate, 3 parts acrylic acid and 25 parts of 1,3-butylene glycol dimethacrylate. It was allowed to swell the initial latex polymer at 45°C and then a redox initiator was used to initiate the polymerization. The final emulsion polymer has 45.8% solids.

Following the procedures of Ex. III, various adhesive compositions within scope of this invention were prepared using the functional acrylic polymer prepared above. The compositions were evaluated for peel strength and compared to comparative compositions falling outside the scope of this invention. The results are presented in Table V.

TABLE V

| (parts by weight) | | | | |
|---|---|---|---|---|
| Sample | Functional Acrylic Polymer | Epoxy Resin (Genepoxy 370H55) | Impact Modifier* | Peel strength (lbs./inch) |
| A A (comparative) | 100 | - | - | 3.4 |
| BB(comparative) | 100 | 6 | - | 15.3 |
| CC | 100 | 6 | 1.0 | 16.5 |
| DD | 100 | 6 | 10 | 22.2 |
| EE | 100 | 6 | 26 | 16.5 |

*Impact Modifier is a commercial acrylic impact modifier comprising 80% butyl acrylate and 20% methyl methacrylate (available from Rohm and Haas Co.)

## Claims

1. A composition comprising:

a) 1% to 30% by weight of a), b) and c) of crosslinking agent(s),

b) 0.1% to 25% by weight of a), b) and c) of impact modifier(s), and

c) 45% to 98.9% by weight of a), b) and c) of a functional acrylic polymer, wherein said functional acrylic polymer comprises from 0.1% to 20% by weight of monomer units containing one or more functional groups which are reactive with said crosslinking agent(s).

2. A composition as claimed in claim 1 wherein said impact modifier is one or more of polyolefins, chlorinated polyethylenes, poly(acrylonitrile/butadiene/styrene), poly(methacrylate/acrylonitrile/butadiene/styrene), poly(methacrylate/butadiene/styrene), polyacrylate, poly(ethylenelvinyl acetate), acrylic polymers and silicone rubber polymers.

3. A composition as claimed in claim 1 or claim 2 wherein said functional acrylic polymer comprises one or more functional groups of carboxylic acids, aliphatic amines, aromatic amines, hydroxyls, amides, thiols, epoxides, anhydrides and phosphorus groups of the formula:

O
||
$-Z-P-OR_1$
|
$OR_2$

where $R_1$ and $R_2$ independently are H or $C_1$-$C_{12}$ alkyl or aryl, and Z is -O-or -C-.

4. A composition as claimed in any one of the preceding claims, wherein said crosslinking agent(s)is one or more of epoxy resins, melamine/formaldehyde resins, beta-hydroxyalkylamides, aziridines, (amino) amides, multifunctional amines and metal ion crosslinkers.

5. Use of a composition as claimed in any one of the preceding claims in or as a contact or laminating adhesive, an architechural caoting, a caulk, a mastic, a cement binder or a paper coating.

6. A process comprising laminating two or more substrates together with a composition comprising:

a) 1% to 30% by weight based on a), b) and c) of crosslinking agent(s)

b) 0.1% to 25% by weight based on a), b) and c) of impact modifier(s), and

c) 45% to 98.9% by weight based on a), b) and c) functional acrylic polymer(s) wherein said acrylic polymer(s) comprises from 0.1% to 20% by weight of monomer units containing one or more functional groups which are reactive with said crosslinking agent(s).

7. A process as claimed in claim 6, wherein said substrates are selected from the group consisting of copper foil, iron foil, nickel foil, aluminum foil, silver foil, gold foil, polyimide filem, polyester film, polyester fibers, glass fibers, polyvinyl flouride film, polyethylene film, polypropylene film and aramid paper.

8. A solid adhesive film comprising a composition as claimed in any one of claims 1-5.

European Patent Office

# EUROPEAN SEARCH REPORT

Application number

EP 90304970.8

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (Int Cl.5) |
| D,A | US - A - 3 808 180 (OWENS) * Claims 1,7,17-19,26,27,29; column 12, line 63 - column 13, line 4 * -- | 1-3,5 | C 08 L 33/00<br>C 08 F 120/02<br>C 09 J 133/00<br>C 09 J 11/00<br>B 32 B 7/12<br>C 08 L 95/00<br>C 09 J 7/00 |
| D,A | US - A - 4 482 659 (SANJANA) * Claims 1,8; column 2, lines 18-27 * ---- | 1,2,6,7 | |
| | | | TECHNICAL FIELDS SEARCHED (Int Cl.5) |
| | | | C 08 F<br>C 09 J<br>B 32 B<br>C 08 L |

The present search report has been drawn up for all claims

| Place of search | Date of completion of the search | Examiner |
|---|---|---|
| VIENNA | 30-08-1990 | BÖHM |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document